(19)

Europäisches
Patentamt
European
Patent Office
Office européen
des brevets

(11) **EP 2 355 350 A1**

(12) **EUROPEAN PATENT APPLICATION**

(43) Date of publication:
**10.08.2011 Bulletin 2011/32**

(51) Int Cl.:
*H03K 3/356* [(2006.01)] *H03K 3/3565* [(2006.01)]
*H03K 5/24* [(2006.01)]

(21) Application number: **10152396.7**

(22) Date of filing: **02.02.2010**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(71) Applicant: **NXP B.V.**
**5656 AG Eindhoven (NL)**

(72) Inventor: **Berkhout, Marco**
**Redhill, Surrey RH1 1DL (GB)**

(74) Representative: **Hardingham, Christopher Mark**
**NXP Semiconductors**
**IP Department**
**Betchworth House**
**57-65 Station Road**
**Redhill,**
**Surrey RH1 1DL (GB)**

(54) **Comparator Circuit**

(57)     A comparator circuit has a switching arrangement between first and second input branches. Second transistors of the first and second input branches (which would normally be the main current mirror transistors in a conventional comparator circuit) have their gates coupled together, and selectively connected to the first or second intermediate voltages of the input branches by the switching arrangement. The digital output voltage of the comparator circuit is used to control the switching arrangement, so that a feedback mechanism is implemented.

FIG. 2

**Description**

This invention relates to comparator circuits.

Comparators are generic building blocks in analogue and mixed-signal systems. Important characteristics of a comparator are offset, propagation delay and hysteresis.

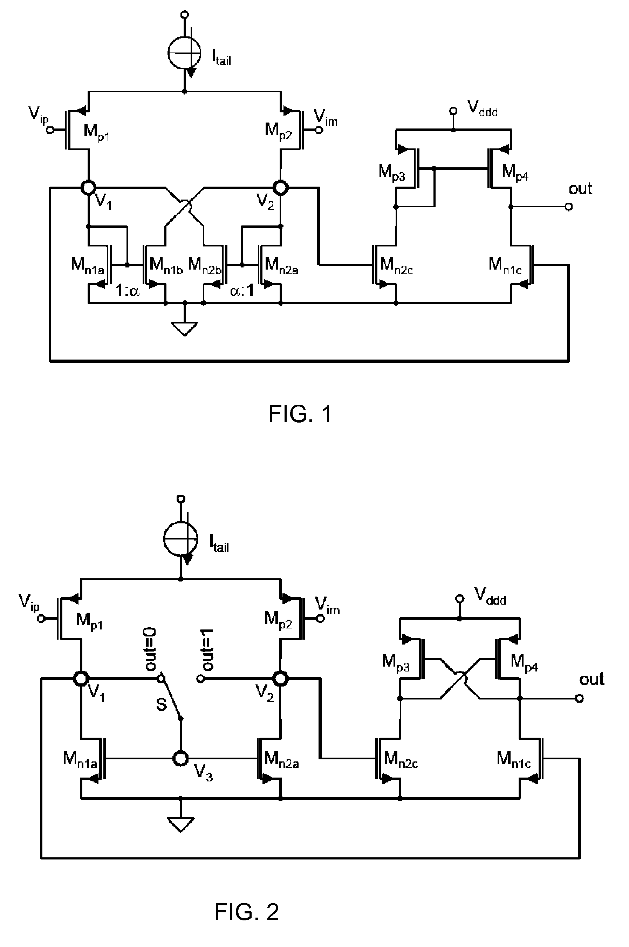

A comparator is a circuit that compares two analogue input voltages. The output of the comparator is a logic signal (0 or 1) depending on which of the analogue input voltages is larger. A well-known comparator circuit topology is shown in Fig 1.

Differential pair Mp1,2 forms the differential input that is loaded with two cross-coupled current mirrors Mn1a, b and Mn2a,b. The cross-coupling results in positive feedback that increases the gain.

The circuit has a current source which feeds first and second input branches. In the transistor names, the first subscript indicates n-type or p-type, and the second subscript indicates the first or second branch.

Each branch has a first transistor Mp1,2 and a current mirror circuit in series, with an intermediate voltage V1,V2 defined at the junction. Each current mirror circuit has a diode-connected main transistor Mn1,2a and a current mirror transistor Mn1,2b. The current mirror circuits mirror the current flowing in the branch (through the main transistor Mn1,2a) to generate a cross coupled component with a ratio $\alpha$.

For correct operation, the current mirrors need to have a mirror ratio $\alpha$ smaller than unity. This is realized by making the diode-connected devices Mn1 a and Mn2a larger than the output devices Mn1 b and Mn2b, e.g. a ratio of 1:0.75 can be used.

In this arrangement, the intermediate (i.e. internal node) voltages V1 and V2 are balanced around a common mode level that is near the threshold voltage of the NMOS transistors. The output stage formed by output transistor Mn1c, Mn2c which are gated by the intermediate voltages V1,V2 of a respective one of the branches, and a current mirror circuit Mp3,4. These components together perform differential to single-ended conversion, and because the mirror is connected to the digital power supply Vddd the output signal level matches the digital signal level.

A possible drawback of the arrangement shown in Fig 1 occurs at very small input signals. In this case it is possible that the output signal floats between Vddd and ground. The comparator becomes very sensitive to disturbances and essentially amplifies any noise present at the input. The output signal is not a strict logic signal anymore and this can cause glitches and unpredictable behaviour in the subsequent digital circuits.

A simple means to solve this problem is to apply hysteresis. This can be done with the same topology but now the mirror ratio $\alpha$ of the current mirrors needs to be greater than unity, e.g. a ratio 1: 1.33. In this case, the cross- coupled current mirrors behave as a regenerative latch. The output now has two stable states: 1 (Vddd) and 0 (ground). Applying hysteresis guarantees that the output signal is strictly logical.

In many applications such as sigma-delta modulators and PWM modulators, hysteresis is an undesired characteristic that causes distortion. Ideally the hysteresis window should be as small as possible while still guaranteeing strictly logical output signals. The size of the hysteresis window is determined by the mirror ratio $\alpha$ of the current mirrors. A small hysteresis window is obtained when $\alpha$ is chosen close to unity. Unfortunately, choosing $\alpha$ close to unity increases the sensitivity to mismatch. For example, if the required mirror ratio $\alpha$ equals 1.05 and the matching between Mn1a and Mn1b has a four-sigma spread of 10%, a significant amount of samples will have no hysteresis at all.

It is well known that matching improves with increasing device area. Consequently, the matching in the example can be improved by making the devices in the current mirrors larger. However, increasing the device size in the mirrors also increases the capacitive load on the differential pair and makes the comparator slower which is undesirable. There is a trade-off between comparator speed and the accuracy of the hysteresis window.

A second disadvantage of the configuration shown in Fig 1 is that the diode connected transistors Mn1a and Mn2a limit the gain that can be achieved on nodes V1 and V2. Most of the current from the differential pair Mp1,2 is drained by Mn1a and Mn2a instead of being used to charge the capacitance on nodes V1 and V2.

According to the invention, there is provided a comparator circuit, comprising an input stage and an output stage, wherein the input stage comprises:

>   a current source;
>   a first input branch comprising first and second transistors in series, with a first intermediate voltage defined at the junction between the two transistors of the first branch; and
>   a second input branch comprising first and second transistors in series, with a second intermediate voltage defined at the junction between the two transistors of the second branch, wherein the current source supplies the first and second input branches;
>   wherein the second transistors of the first and second input branches have their gates coupled together, and selectively connected to the first or second intermediate voltage by means of a switching arrangement,
>   wherein the output stage generates a digital output from the first and second intermediate voltages, and wherein the digital output voltage is used to control the switching arrangement.

The invention provides a circuit topology which improves the sensitivity to mismatch of a hysteretic comparator. The reduced sensitivity allows the use of much smaller devices that reduce the capacitive load on internal circuit nodes resulting in a much faster response. In particular, for maximal speed it is best to minimize the capacitive load of the differential pair. Thus minimum size devices are preferred.

The circuit has two states that depend on the output signal, and there is effectively a hysteresis implemented by means of the threshold voltages of the second transistors of the input branches.

In one arrangement, the first transistors of the first and second input branches comprise p-type transistors and the second transistors of the first and second input branches comprise n-type transistors.

The current source can be connected between a high voltage line (e.g. the voltage corresponding to a digital high of the comparator) and the p-type first transistors and the n-type second transistors are then connected to a low voltage line (e.g. ground).

The output stage preferably comprises a differential to single-ended signal converter.

In one example, the output stage comprises:

a first output branch comprising first and second output transistors in series; and
a second output branch comprising first and second output transistors in series,
wherein the first output transistors of the first and second output branches are cross connected with the gates of each connected to the drain of the other, and the drain of one of the first output transistor defining the output, and
wherein the second output transistors of the first and second output branches are each provided with a respective one of the intermediate voltages at their gate.

This arrangement defines a cross coupled transistor pair at the output.

The first output transistors of the first and second output branches can be p-type with their sources connected to a high voltage line, and the second output transistors of the first and second output branches are then n-type with their sources connected to a low voltage line. The cross coupled pair is then a p-type pair.

The switching arrangement can comprise first and second transmission gates which are switched oppositely. Each transmission gate can comprises an n-type transistor and a p-type transistor in parallel, with one having the digital output provided to the gate and the other having a signal opposite to the digital output, from the output stage, provided to the gate. For example, the cross coupled transistor pair can generate the output as one of the gate voltages and the opposite signal as the other of the gate voltages. This provides a simple feedback circuit implementation.

The circuit can be implemented as a CMOS circuit with NMOS and PMOS transistors.

The invention also provides a method of controlling a comparator circuit, wherein the comparator circuit comprises:

an input stage and an output stage, wherein the input stage comprises:

a current source;
a first input branch comprising first and second transistors in series, with a first intermediate voltage defined at the junction between the two transistors of the first branch; and
a second input branch comprising first and second transistors in series, with a second intermediate voltage defined at the junction between the two transistors of the first branch, wherein the current source supplies the first and second input branches,

wherein the method comprises:

generating a digital output from the first and second intermediate voltages using the output stage; and
using a switching arrangement to selectively connect the first or second intermediate voltage to the gates of the second transistors of the first and second input branches, and controlling the switching arrangement based on the digital output from the output stage.

An example of the invention will now be described in detail with reference to the accompanying drawings, in which:

Figure 1 shows a known comparator circuit;
Figure 2 shows schematically a first example of comparator circuit of the invention;
Figure 3 is a simplified diagram showing the comparator circuit of the invention with a first output value;
Figure 4 is a simplified diagram showing the comparator circuit of the invention with a second output value;
Figure 5 shows the response of the comparator circuit to a triangular input voltage;

Figure 6 shows the influence of a mismatch between transistors in the circuit on hysteresis;
Figure 7 shows the hysteresis curves for maximum and minimum offset and hysteresis window;
Figure 8 shows the propagation delay response of the comparator to a $\pm$100mV step at the input; and
Figure 9 shows a more detailed implementation of the circuit of Figure 2.

The invention provides a comparator circuit in which a switching arrangement is used between the first and second input branches. The second transistors of the first and second input branches (which would normally be the main current mirror transistors) have their gates coupled together, and selectively connected to the first or second intermediate voltages of the input branches by the switching arrangement. The digital output voltage of the comparator circuit is used to control the switching arrangement, so that a feedback mechanism is implemented.

Figure 2 shows a first example of comparator circuit of the invention.

As in the circuit of Figure 1, the circuit has a current source $I_{tail}$ which feeds first and second input branches.

The first input branch comprises first and second transistors Mp1, Mn1 a in series, with a first intermediate voltage V1 defined at the junction between the two transistors of the first branch. The second input branch comprises first and second transistors Mp2, M2a in series, with a second intermediate voltage V2 defined at the junction between the two transistors of the second branch.

Instead of using the second transistors to implement current mirror circuits, the second transistors Mn1,2a of the first and second input branches have their gates coupled together (node V3), and selectively connected to the first or second intermediate voltage V1 or V2 by means of a switching arrangement S. This means that only one of the transistors Mn1 a or Mn2a is diode-connected within its branch.

The switching arrangement S is controlled in dependence on the digital output ("out").

The output stage is modified in that it comprises a first output branch comprising first and second output transistors Mp3, Mn2c in series; and a second output branch comprising first and second output transistors Mp4, Mn1 c in series. The first output transistors are cross connected with the gates of each connected to the drain of the other, and the drain of one of the first output transistor defining the output (out). As in Figure 1, the intermediate voltages V1,V2 are coupled to the gates of the transistors Mn2c, Mn1c.

With the exception of the input transistor pair Mp1,2 the comparator topology shown in Fig 2 uses only very small devices. The main difference over the conventional arrangement is the use of a switching arrangement S that connects node V3 (the gates of the lower transistors in the branches) to either intermediate voltage V1 or V2 depending on the state of the output "out".

Any mismatch between transistors Mn1a and Mn2a can be translated as an additional offset term at the input but does not influence the hysteresis window. The size of the hysteresis window is determined by the transconductance of the differential pair Mp1,2 and the output impedance Mn1a and Mn2a. Mismatch between devices has only very small influence.

Further, since only one of the transistors Mn1a or Mn2a is diode connected depending on the state of switch S, only one of the nodes V1 or V2 has limited voltage gain. The voltage gain on the opposite node is not limited as in the prior-art circuit. Consequently, all current from the differential pair Mp1,2 is used effectively to charge that node yielding a much faster response.

The proposed comparator has two states that depend on the output signal that is latched by the cross coupled PMOS pair Mp3,4.

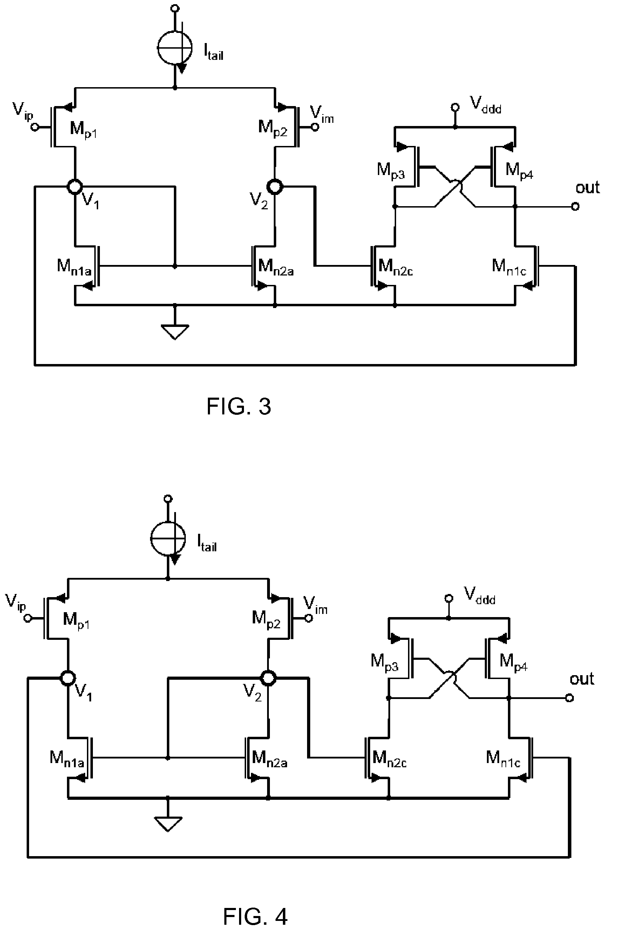

First assume the output signal is low and a rising zero-crossing appears at the differential input Vip-Vim. In this state the circuit can be simplified to the circuit shown in Fig 3.

Near the zero-crossing the tail current distributes evenly between Mp1 and Mp2. Consequently the voltage on nodes V1 and V2 is about equal and slightly higher than the threshold voltage VT of the NMOS transistors. Both pull-down transistors Mn1c and Mn2c (the second transistors in the branches of the output stage) are conducting but because Mp3 is on and Mp4 is turned off the output "out" remains low. In order to change the state of the latch voltage V2 needs to be higher than voltage V1 by a significant amount $\delta V$:

$$(1) \quad V2 = V1 + \delta V$$

The magnitude of this voltage difference $\delta V$ depends on the dimensions of Mp3 and Mn2c but is typically a few 100mV's higher than the threshold of Mn2c and is rather insensitive to temperature variations or small variations in device dimensions.

In the configuration shown in Fig. 3, V2 is a high-impedance node. The small-signal gain from the differential input voltage Vi=Vip-Vim to V2 is approximately:

$$(2) \qquad \frac{V_2}{V_i} = g_{m,i} \cdot r_{o,V2}$$

where $g_{m,i}$ is the transconductance of differential pair Mp1,2 and $r_{o,V2}$ is the output impedance of Mn2a in parallel to the output impedance of differential pair Mp1,2.

With equation (2) the input voltage Vi needed to toggle the output latch can be approximated:

$$(3) \qquad V_i = \frac{\delta V}{g_{m,i} \cdot r_{o,V2}}$$

When the latch toggles the output out goes high and the state of the circuit is changed to the configuration shown in Fig 4.

Shorting the drain and gate of Mn2a forces both V1 and V2 to drop down $\delta$V acting affirmatively on the latching. The new configuration is essentially a mirror image of the previous one. The sequence of events following a falling edge zero-crossing of the input voltage is a repetition of steps with the role of V1 and V2 interchanged.

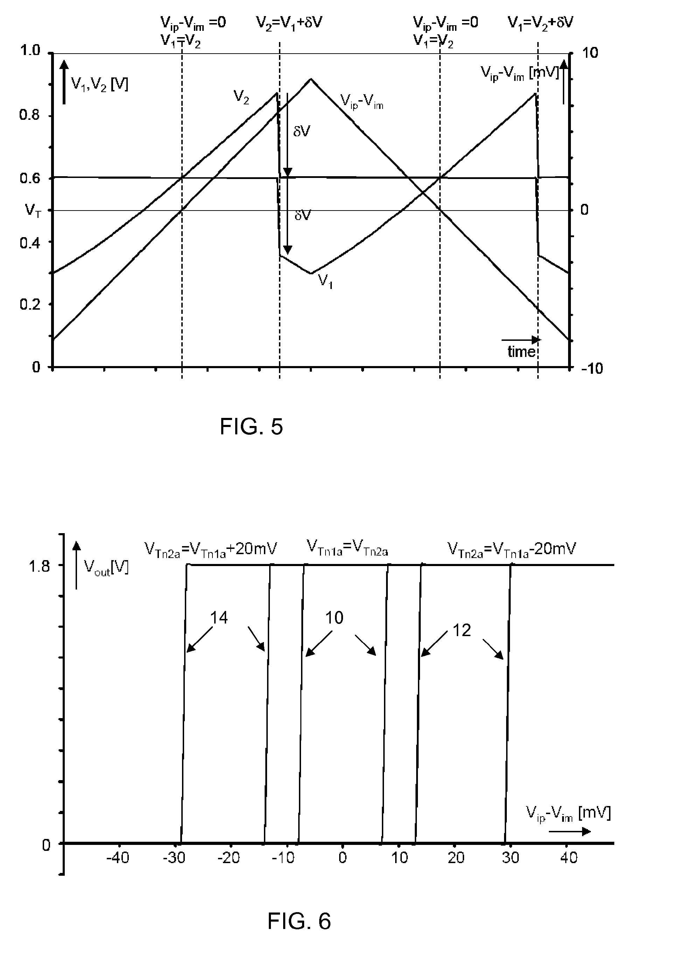

The behaviour of voltages V1 and V2 when a triangular input voltage Vip-Vim is applied is shown in Fig 5.

The toggling of the output can be seen when the input voltage reaches a point such that V2=V1 + $\delta$V and again when V1 = V2 + $\delta$V.

Fig. 6. shows the influence of a mismatch between Mn1a and Mn2a on hysteresis.

The curves 10 show the nominal case where the hysteresis window lies symmetrically around zero. The curves 12 show the case where the threshold voltage of Mn2a is 20mV lower than the threshold voltage of Mn1a whereas the curves 14 show the opposite case where the threshold voltage of Mn2a is 20mV higher than the threshold voltage of Mn1a. As can be seen in Fig. 6, mismatch between Mn1a and Mn2a results in offset but does not influence the hysteresis window (i.e. width). A Monte-Carlo analysis over 1000 trials gives the following results:

|  | nominal | mean | 1σ spread | min | max |
| --- | --- | --- | --- | --- | --- |
| low threshold | -7 6 | -7.1 | 10 4 | -42.9 | 25.9 |
| high threshold | 7 6 | 7.9 | 10 4 | 27.7 | 40.9 |
| hysteresis | 15.2 | 15.0 | 0.4 | 13.7 | 16.3 |

It can be seen that the spread on the hysteresis window is much smaller than the spread on the high and low threshold levels.

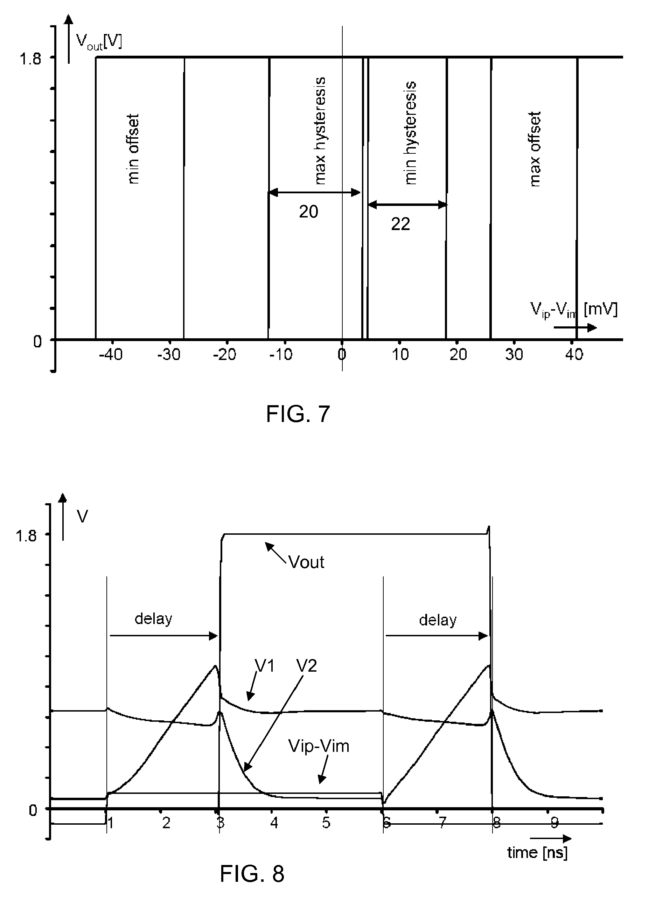

In Fig. 7 the hysteresis curves are shown that correspond to these extremes. The curves 20 and 22 show the cases with maximum and minimum hysteresis window. As can be seen, the sensitivity of the hysteresis window to matching is very small.

Fig. 8 shows the response of the comparator to a $\pm$100mV step at the input. As can be seen the propagation delay is close to 2ns for both rising and falling transitions. This very high speed is possible because of the very small components used in the comparator and the high gain that is realized on either node V1 or V2.

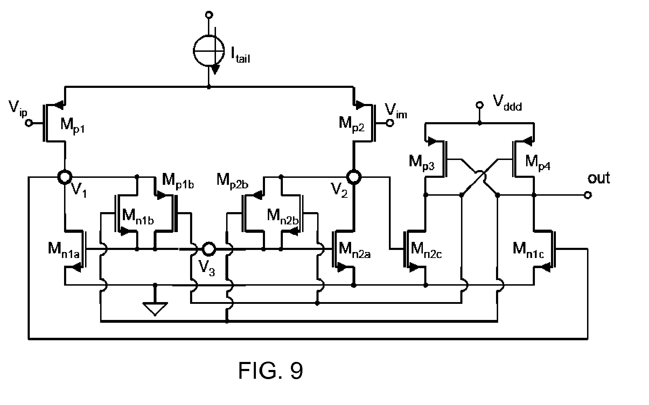

A more complete implementation is shown in Fig. 9.

The switch S arrangement from Fig 2 is implemented by two transmission gates Mn1p/Mp1b and Mn2b/Mn2b.

The first and second transmission gates are switched oppositely. Each transmission gate comprises an n-type transistor and a p-type transistor in parallel, with one having the digital output "out" provided to the gate and the other having a signal opposite to the digital output, from the output stage, provided to the gate.

The invention is specifically useful in continuous-time, asynchronous applications such as PWM modulators and all kinds of protection circuits where fast response times are crucial.

Only one example of circuit has been given. However, it will be understood that other arrangements are possible, for example by changing the circuit polarities and changing n-type devices for p-type devices, and vice versa. Thus, a complementary implementation to that shown is equally possible. Furthermore, the circuit shown is the most basic implementation, and additional circuit components may be present. The possibility to implement the invention in different configurations will be apparent to those skilled in the art.

Various other modifications will be apparent to those skilled in the art.

**Claims**

1.  A comparator circuit, comprising an input stage and an output stage, wherein the input stage comprises:

    a current source (Itail);
    a first input branch comprising first and second transistors (Mp1,Mn1a) in series, with a first intermediate voltage (V1) defined at the junction between the two transistors of the first branch; and
    a second input branch comprising first and second transistors (Mp2,Mn2a) in series, with a second intermediate voltage (V2) defined at the junction between the two transistors of the second branch, wherein the current source (Itail) supplies the first and second input branches;
    wherein the second transistors (Mn1a,Mn2a) of the first and second input branches have their gates coupled together, and selectively connected to the first or second intermediate voltage (V1,V2) by means of a switching arrangement (S),
    wherein the output stage generates a digital output (out) from the first and second intermediate voltages (V1,V2), and wherein the digital output voltage (out) is used to control the switching arrangement (S).

2.  A circuit as claimed in claim 1, wherein the first transistors (Mp1,Mp2) of the first and second input branches comprise p-type transistors and the second transistors (Mn1a,Mn2a) of the first and second input branches comprise n-type transistors.

3.  A circuit as claimed in claim 2, wherein the current source (Itail) is connected between a high voltage line and the p-type first transistors (Mp1,Mp2) and the n-type second transistors are connected to a low voltage line.

4.  A circuit as claimed in any preceding claim, wherein the output stage comprises a differential to single-ended signal converter.

5.  A circuit as claimed in claim 4, wherein the output stage comprises:

    a first output branch comprising first and second output transistors (Mp3,Mn2c) in series; and
    a second output branch comprising first and second output transistors (Mp4,Mn1c) in series,
    wherein the first output transistors (Mp3,Mp4) of the first and second output branches are cross connected with the gates of each connected to the drain of the other, and the drain of one of the first output transistor defining the output (out), and
    wherein the second output transistors (Mn2c,Mn1c) of the first and second output branches are each provided with a respective one of the intermediate voltages (V1,V2) at their gate.

6.  A circuit as claimed in claim 5, wherein the first output transistors (Mp3,Mp4) of the first and second output branches are p-type with their sources connected to a high voltage line, and the second output transistors (Mn2c,Mn1c) of the first and second output branches are n-type with their sources connected to a low voltage line.

7.  A circuit as claimed in any preceding claim, wherein the switching arrangement (S) comprises first and second transmission gates which are switched oppositely.

8.  A circuit as claimed in claim 7, wherein each transmission gate comprises an n-type transistor (Mn1b,Mn2b) and a p-type transistor (Mp1b,Mp2b) in parallel, with one having the digital output provided to the gate and the other having a signal opposite to the digital output, from the output stage, provided to the gate.

9.  A circuit as claimed in any preceding claim, comprising a CMOS circuit.

10. A method of controlling a comparator circuit, wherein the comparator circuit comprises:

    an input stage and an output stage, wherein the input stage comprises:

a current source (Itail);
a first input branch comprising first and second transistors (Mp1,Mn1a) in series, with a first intermediate voltage (V1) defined at the junction between the two transistors of the first branch; and
a second input branch comprising first and second transistors (Mp2,M2na) in series, with a second intermediate voltage (V2) defined at the junction between the two transistors of the first branch, wherein the current source (Itail) supplies the first and second input branches,

wherein the method comprises:

generating a digital output (out) from the first and second intermediate voltages (V1,V2) using the output stage; and
using a switching arrangement (S) to selectively connect the first or second intermediate voltage (V1,V2) to the gates of the second transistors of the first and second input branches, and controlling the switching arrangement (S) based on the digital output (out) from the output stage.

FIG. 1

FIG. 2

FIG. 3

FIG. 4

FIG. 5

FIG. 6

FIG. 7

FIG. 8

FIG. 9

**Europäisches Patentamt**

**European Patent Office**

**Office européen des brevets**

# EUROPEAN SEARCH REPORT

Application Number

EP 10 15 2396

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2007/164801 A1 (CHEN YI-CHEN [TW] ET AL) 19 July 2007 (2007-07-19) * paragraphs [0020] - [0024]; figures 2,3A,3B * ----- | 1-10 | INV. H03K3/356 H03K3/3565 H03K5/24 |

| TECHNICAL FIELDS SEARCHED (IPC) |
|---|
| H03K |

The present search report has been drawn up for all claims

| Place of search | Date of completion of the search | Examiner |
|---|---|---|
| The Hague | 18 March 2011 | Meulemans, Bart |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 10 15 2396

This annex lists the patent family members relating to the patent documents cited in the above-mentioned European search report.
The members are as contained in the European Patent Office EDP file on
The European Patent Office is in no way liable for these particulars which are merely given for the purpose of information.

18-03-2011

| Patent document cited in search report | Publication date | Patent family member(s) | Publication date |
|---|---|---|---|
| US 2007164801 A1 | 19-07-2007 | NONE | |

For more details about this annex : see Official Journal of the European Patent Office, No. 12/82